# EUROPEAN PATENT SPECIFICATION

(11) **EP 4 609 210 B1**
(45) Date of publication and mention of the grant of the patent: **02.12.2026**
(21) Application number: 23799022.1
(22) Date of filing: 25.10.2023
(51) Int. Cl.: G01R 31/12, G01R 31/52, H02H 1/06

(54) **MONITORING APPARATUS AND CORRESPONDING OPERATING METHOD**
ÜBERWACHUNGSVORRICHTUNG UND ZUGEHÖRIGES BETRIEBSVERFAHREN
APPAREIL DE SURVEILLANCE ET PROCÉDÉ DE FONCTIONNEMENT CORRESPONDANT

(30) Priority: 28.10.2022 IT 202200022233
(43) Date of publication of application: 03.09.2025
(73) Proprietor: Eurotech S.P.A., 33020 Amaro (UD) (IT)
(72) Inventor: PADULOSI, Ugo, 33035 Martignacco (UD) (IT)
(74) Representative: Petraz, Davide Luigi
(86) International application number: PCT/IT2023/050240
(87) International publication number: WO 2024/089720

(56) References cited:
- US-A1- 2015 128 733
- US-A1- 2017 168 106
- US-A1- 2019 227 110
- US-A1- 2020 303 950
- US-A1- 2022 149 611

## Description

### FIELD OF THE INVENTION

The present invention concerns a monitoring apparatus suitable at least to detect surface leakage currents on an insulating element and a corresponding operating method.

In particular, the monitoring apparatus can be advantageously applied to insulating elements such as, by way of non-exhaustive examples, insulators or insulating surfaces for coating pylons of medium and high voltage lines, insulation of transformers, insulating systems for high voltage industrial plants, elements coated with insulating material immersed in electric fields, high intensity magnetic or electromagnetic fields and suchlike.

### BACKGROUND OF THE INVENTION

It is known that in the case of systems and equipment that provide to use high electric currents and voltages, such as for example pylons for supporting medium/high voltage cables, medium/high voltage transformers, industrial plants, electrical cabinets or suchlike, there is a need to provide insulating means, or elements, both for reasons of safety of possible operators and also to limit the dispersion of energy into the environment.

Such insulating means may generally be made of a plurality of different materials, provided that they are electrically non-conductive, such as glass, ceramic, plastic, polymeric or silicone-based materials for example, or suchlike.

It is also known that the mechanical and electrical characteristics of the insulating elements can degrade, due to the aging of the insulating materials, electrical or mechanical events, or suchlike. Their performance can also be affected by environmental conditions, for example by the degree of humidity and/or salinity of the air, by rain, or other.

To guarantee the required safety conditions are maintained, it is therefore necessary to verify the effective operation of the insulating elements and, where necessary, carry out their maintenance.

For example, in the event that the insulating elements are insulators for medium and high voltage electric power supply lines, intended as elements capable of supporting and joining the line cables to towers/pylons/trusses, appropriately insulating them from the latter, or the pylons themselves, which are generally coated with insulating or non-conductive paints, any breakage or degradation of the insulating means could also result in a malfunction in the transport of energy.

To keep the insulating means efficient it is therefore necessary to keep them monitored. However, the insulating means may not be easily accessible to an operator for measuring operations, for example because they are located on pylons several meters from the ground, because they are housed in areas at electrical risk or inside industrial plants or suchlike.

On the other hand, providing possible sensors or detection devices positioned in proximity to the systems and apparatuses that manage high electric currents or voltages entails considerable costs, in addition to the need to provide an appropriate source of electrical power for each one.

There is therefore the need to perfect a monitoring apparatus that can overcome at least one of the disadvantages of the state of the art.

To do this, it is necessary to solve the technical problem of identifying a technology and a method to power transducer devices, reducing the power supply to be provided as much as possible. US 2017/168106 A1 is known from the prior art and it discloses a sensor for detecting electrical current on an insulating element of a rail system, comprising: at least one electrically conductive lead or wire for attaching the sensor to the insulating element; an energy harvester for harvesting electric current transmitted from the insulating element to the energy harvester via the lead; a microprocessor circuit including a capacitor wherein the capacitor is charged by energy harvested by the energy harvester; and a transmitter for wirelessly transmitting RF signals indicative of the detected current; wherein the microprocessor and transmitter are powered by the energy from the capacitor.

In particular, one purpose of the present invention is to provide a monitoring apparatus, and perfect a method, suitable to monitor characteristics of the insulating elements that is as autonomous as possible from the electric power supply point of view.

Another purpose of the present invention is to provide a monitoring apparatus that does not require the on-site intervention of an operator to obtain information on the insulating elements with which it is associated.

Another purpose of the present invention is to provide a monitoring apparatus that can also be used in real time to transmit information remotely.

Another purpose of the present invention is to provide a monitoring apparatus that can be used to measure a plurality of physical characteristics of an insulating element, but also to measure environmental parameters.

Another purpose of the present invention is to provide a monitoring apparatus that is simple and with a reduced number of components, so as to keep construction costs low.

Another purpose of the present invention is to provide a monitoring apparatus that can be applied to an insulating element in a simple manner.

The Applicant has devised, tested and embodied the present invention to overcome the shortcomings of the state of the art and to obtain these and other purposes and advantages.

### SUMMARY OF THE INVENTION

The present invention is set forth and characterized in the independent claims. The dependent claims describe other characteristics of the present invention or variants to the main inventive idea.

In accordance with the above purposes and to resolve the technical problem disclosed above in a new and original way, also achieving considerable advantages compared to the state of the prior art, a monitoring apparatus according to the present invention for an insulating element comprises a surface leakage current collection element provided with two conductive grip elements which are configured to be connected, during use, to an insulating element, a device for storing the energy associated with the leakage current, a module for detecting the leakage current and a remote transmission module configured to be powered by the storage device and to transmit at least the information relating to a physical quantity correlated to the leakage current measured by the detection module.

The apparatus is configured to be connected to an insulating element which is associated with, or located in proximity to, equipment configured to operate with high electric voltages and/or currents.

Doing so achieves at least the advantage that the monitoring apparatus is electrically powered by the energy of the leakage currents present on the separation surface between the insulating element and the surrounding air, energy that would be dispersed into the environment, thus allowing to save energy.

In accordance with another aspect of the present invention, the detection module and the storage device are integrated in a single electric circuit.

In accordance with one aspect of the present invention, the detection module comprises at least one measurement device configured to cooperate with the storage device for the indirect measurement of the leakage current.

In particular, the first measurement device is configured to measure the amount of surface current flowing at the ends of the grip elements, based on the charging time of the storage device.

This effectively allows to simultaneously achieve both the power supply of the monitoring device and also the acquisition of information regarding the surface leakage current.

According to some embodiments, the transmission module is configured to transmit a remote signal every time a sufficient amount of energy is present in the storage device to provide an adequate electric power supply.

In accordance with another aspect of the present invention, the detection module comprises a second device for measuring the leakage current, additional or alternative to the first measurement device, and a division device, chosen from a switch or a divider, configured to send a part of the leakage current to the storage device and another part to the second measurement device.

In accordance with another aspect of the present invention, the detection module comprises at least one device for detecting the mechanical stress on the structure of the insulating element and/or of equipment with which the insulating element is associated. The at least one detection device is a strain gauge or an ultrasonic sensor.

Advantageously, since the sensors as above are comprised in the apparatus, and can be located in proximity to the management unit that acquires its data, they can be integrated into the same protective casing, with notable advantages in production times and costs.

In accordance with another aspect of the present invention, a monitoring platform for an insulating element associated with electronic equipment comprises at least one monitoring apparatus according to the invention, a Gateway, one or more data processing and cloud storage units and one or more local terminals.

According to another aspect of the invention, the platform comprises at least one group of monitoring apparatuses connected to insulating elements associated with, or located in correspondence with, the same equipment, wherein the apparatuses of the group are configured to communicate with each other or simultaneously transmit signals to at least one data processing and storage unit, which is configured to process and cross the received signals and obtain additional information on the characteristics of one of the apparatuses of the group, or on the characteristics of the equipment associated with the group.

The present invention also concerns a method for monitoring at least one insulating element, which comprises:
- connecting an apparatus to an insulating element associated with, or located in proximity to, equipment configured to operate with high electric voltages and/or currents;
- collecting a surface leakage current of the insulating element by means of conductive grip elements placed in contact with it;
- sending the energy associated with the leakage current to a storage device;
- powering a detection module by means of the storage device and detecting a leakage current on the basis of the stored energy;
- transmitting at least information relating to a physical quantity correlated to the leakage current measured, by means of a remote transmission module.

In accordance with another aspect of the present invention, the method comprises detecting the non-ideality of the surface of the insulating element by means of redundant measurements of the received signal strength on different communication paths between a multiplicity of the apparatuses.

### DESCRIPTION OF THE DRAWINGS

These and other aspects, characteristics and advantages of the present invention will become apparent from the following description of some embodiments, given as a non-restrictive example with reference to the attached drawings wherein:
- fig. 1 is a three-dimensional representation of a monitoring apparatus, according to the present invention;
- figs. 2 and 3 are block representations of the monitoring apparatus of fig. 1, according to different embodiments;
- figs. 4a and 4b are a schematic, lateral and sectional representation of the monitoring apparatus of fig. 1;
- figs. 5a and 5b are a schematic, lateral and sectional representation of a monitoring apparatus according to a variant;
- figs. 6 and 7 are schematic representations of a platform comprising the monitoring apparatus of fig. 1 applied to an electric power supply line, according to different embodiments.

We must clarify that the phraseology and terminology used in the present description, as well as the figures in the attached drawings also in relation as to how described, have the sole function of better illustrating and explaining the present invention, their purpose being to provide a non-limiting example of the invention itself, since the scope of protection is defined by the claims.

To facilitate comprehension, the same reference numbers have been used, where possible, to identify identical common elements in the drawings. It is understood that elements and characteristics of one embodiment can be conveniently combined or incorporated into other embodiments without further clarifications.

### DESCRIPTION OF SOME EMBODIMENTS OF THE PRESENT INVENTION

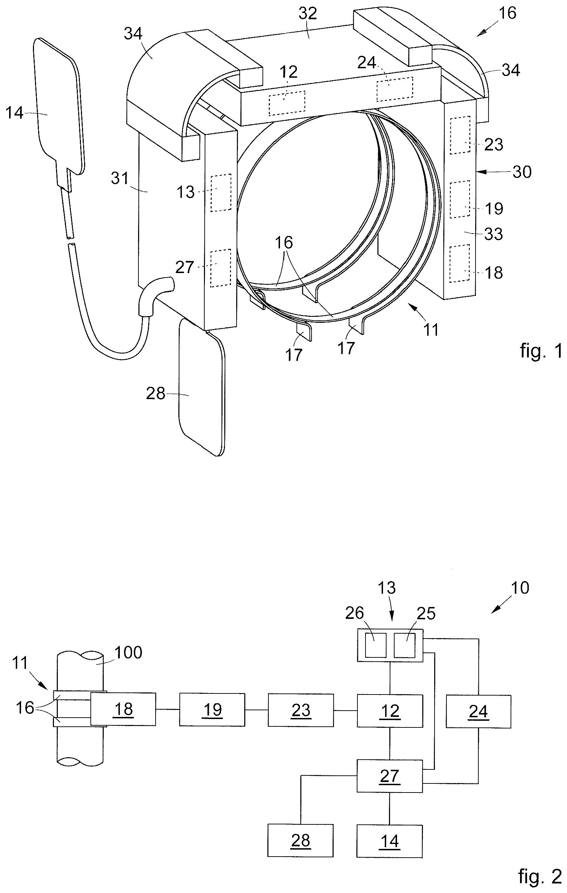

With reference to fig. 1, a monitoring apparatus 10 for an insulating element 100 according to the present invention comprises a device 11 for collecting the surface leakage current of the insulating element 100, a device 12 for storing the energy associated with the leakage current, a module 13 for detecting the leakage current, which can be powered by means of the leakage energy stored, and a remote data transmission module 14.

By leakage current, in the present description and in the attached claims we mean the eddy current that is generated on the surface, not ideal, of the insulating element 100 due to the medium or high intensity electromagnetic field in which the insulating element 100 is immersed. In particular, the non-ideality of the surface of the insulating element 100 may be due to the non-ideality of the materials of the insulating element 100 or with which the insulating element 100 is coated, which may be damaged by the presence of moisture, water, dirt deposited on the surface and suchlike.

The insulating element 100 can be any mean associated with equipment 110 or a system that provides to use high electric currents and voltages, such as for example pylons for supporting medium/high voltage cables, medium/high voltage transformers, industrial plants, electrical cabins, electric power supply lines 102, or suchlike.

The insulating elements 100 are characterized by materials and shapes that have a "low" availability for the transport of electric charges, where the term "low" is in relation to the scope of use and application. The insulating elements 100 in question can generally be made of a plurality of different materials, provided that they are either non-conductive or have low conductivity, from an electrical point of view, such as glass, ceramic, plastic, polymeric or silicone-based materials for example, or suchlike. An insulating element 100 can also be a non-conductive paint, such as the one generally used to coat pylons for supporting cables, or an element comprising separation surfaces between materials with different ε (electric permittivity or dielectric constant) and/or µ (magnetic permeability).

For example, in the case of a line 102, leakage currents are generated when the cables constituting the line 102 are placed under tension, then powered. In particular, the line current flowing in the cables generates the aforementioned electromagnetic field.

The collection device 11 comprises two conductive grip elements 17 which, during use, are placed in contact with the insulating element 100.

The collection device 11 can also comprise two conductive bands, or strips, 16 associated with the insulating element 100, to which the conductive grip elements 17 can be connected.

The strips 16 have a lower input impedance than the surface of the insulating element 100; they can therefore create a preferential path for the collection of the leakage current.

The strips 16 are configured to be positioned on the surface of the insulating element 100, intercepting the path of the leakage current, and to allow a good electrical contact with the surface itself. The strips 16 can be made of films of polyimide, aramid paper, silicone or suchlike, on which a conductive film is laid, for example of copper, gold or suchlike.

In particular, the collection device 11 is able to transform the leakage current from a "Maxwellian" type surface current to an "ohmic", or resistive, current.

The grip elements 17 are configured to be placed in electrical contact with the strips 16 and are each connected to one end of a coupling element 18 of the apparatus 10. The grip elements 17 can be metal clamps (fig. 1), metal staples, continuation segments of the strips 16 or suchlike.

The grip elements 17 thus constitute a low impedance path for the leakage current toward the coupling element 18.

The grip elements 17, as shown in the attached drawings, can also mechanically sustain the apparatus 10 in correspondence with the insulating element 100.

For example, the grip elements 17 can be made as flexible arms suitable to be spread apart with respect to each other in order to be at least partly wrapped around an insulating element 100.

According to embodiments not shown, the mechanical attachment is guaranteed by other attachment means, which can advantageously be of a removable type, or even of a fixed type.

The coupling element 18 comprises a low impedance path for the leakage current.

The apparatus 10 comprises a device 19 for protection from overcurrents, for example from overcurrents caused by faults, lightning or suchlike that affect the line 102, machine or plant in correspondence with which the insulating element 100 is positioned. The protection device 19 can be positioned immediately downstream of the coupling element 18.

The apparatus 10 can also comprise a rectifier device 23, configured to convert the variable current into direct current to be sent to the storage device 12.

The rectifier device 23 may be a single half-wave rectifier, a Graetz bridge rectifier or suchlike, preferably it is a low consumption device.

The storage device 12 can comprise dynamic backup components, such as capacitors or supercaps, and/or static backup components, such as batteries, rechargeable batteries, or suchlike. Advantageously, the storage device 12 receives and stores the electrical energy collected by the collection device 11 and directly or indirectly powers the components of the apparatus 10.

The apparatus 10 can also comprise a buffer battery 24, for powering the apparatus 10 when no leakage currents are present, that is, when the equipment 110, for example the line 102, the machine, the plant or suchlike are not in operation, or the apparatus 10 is not connected to the surface of the insulating element 100.

The detection module 13 is configured to detect at least the leakage current.

In particular, the detection module 13 is configured to detect the leakage current on the basis of the energy stored in the storage device 12.

The detection module 13 can comprise at least a first leakage current measurement device 25 (fig. 2). The first measurement device 25 can be configured to perform an indirect measurement of the leakage current.

For example, the first measurement device 25 can cooperate with the storage device 12 to detect the speed of variation of the charge level and/or the charging time of a backup component, such as a capacitor, and indirectly estimate an amplitude value of the leakage current. In particular, a charge state of the backup component can be communicated to the management unit 27 through a signal that ends a sleep state of the management unit 27 itself. The management unit 27 can return to the sleep state at the end of the data transmission. The time interval between two "awakenings" of the management unit can be associated with the charging time of the backup component and therefore with the amplitude of the leakage current. To improve accuracy, the management unit 27 can discharge the charge remaining on the backup component, or use it to recharge the buffer battery 24, if present, before entering sleep state.

The calculation of the leakage current can be carried out by the management unit 27, if the buffer battery 24 is present: the sleep state is supported by the buffer battery 24, with currents of the order of nanoamperes, which keep alive only a real-time clock (RTC) of the management unit 27, by means of which, upon awakening, the management unit 27 calculates the sleep time and therefore the leakage current, manages any detection devices 26, composes the message with the data and transmits it.

The calculation of the leakage current can alternatively be carried out by a Gateway 51, based on the time interval in which it receives the data, for example if the monitoring apparatus 10 does not comprise a buffer battery 24 and therefore the accumulated charge is not sufficient for the necessary computational calculation.

According to some embodiments, the detection module 13 can also comprise one or more of the aforementioned detection devices 26 (fig. 2), such as temperature or position sensors, strain gauges, deformation sensors, accelerometers or suchlike. These detection devices 26 can also be powered, when available, by means of the leakage current obtained from the collection device 11.

By way of example, the measurement of the temperature of the insulating element 100 can give indications on the aging of the materials and/or detect critical situations also of the equipment 110 with which it is associated; the measurement of the position, in particular of the angles of inclination, of the insulator can give indications on any mechanical anomalies.

As another example, a strain gauge or deformation sensor can monitor any mechanical stresses on the insulating element, or possibly on the equipment 110 with which it is associated, or any breakages. For example, the catenaries of the cables of the high-voltage lines, connected by means of insulators to the arms of the pylon, impose mechanical stresses that also depend on the environmental conditions to which they are subjected, such as the presence of ice and/or wind.

The strain gauge can be made integral, by means of suitable gluing, or fused inside the insulating element 100, for example an insulator for a pylon, or glued to the mechanical sustaining elements, for example the attachment fasteners, on the arms of a pylon or suchlike, in order to detect the mechanical stress to which they are subjected.

The present invention therefore allows to prevent current problems such as, for example, the fact that the sensors are generally powered with 4-20 mA power cables even several meters long that can collect electrical events and download them onto the respective acquisition/processing units, the fact that the installation of the sensors requires long and expensive operations, or suchlike.

As another example, as an alternative to the strain gauges, an ultrasonic sensor that exploits the following relationship of the pressure waves can be used to detect the mechanical stress: $c = \left(1/ρκ\right) 0.5$ where:
c: pressure wave velocity;
ρ: density of the material;
κ: compressibility of the material.

The velocity of an ultrasonic wave traveling through a steel element, for example a bar with a 10 cm² section, can be modified due to the density variation linked to longitudinal deformations, which can be of the order of 0.01% on a load of one ton.

The ultrasonic sensor as above can therefore be integrated in the apparatus 10, so as to optimize the energy necessary for its electric power supply and the space required to position it, detecting the reflection/refraction of the waves generated by an ultrasonic source integrated in the apparatus 10 itself and suitably positioned, for example, on the side of a steel attachment fastener of the insulator.

According to one aspect of the invention, the apparatus 10 comprises a management unit 27 of the apparatus 10 configured to regulate at least the operation of the collection device 11, of the storage device 12, of the detection module 13 and of the transmission module 14 and, where present, of the buffer battery 24 in such a way as to use the energy stored therein when the equipment 110 associated with the insulating element 100 is not operational.

The management unit 27 can comprise one or more processing devices and one or more storage devices.

The processing devices can be any form of microcontroller, microprocessor, processor or suchlike usable in computing for data processing and management of electronic or electromechanical devices.

The storage devices can be connected to the processing devices and be among those commercially available, such as a random access memory (RAM), a read-only memory (ROM), mass memory, or any other form of digital storage whatsoever.

The storage devices can be configured to store one or more algorithms for managing the leakage energy, the detection module 13 and the data detected by it.

The management unit 27 can be configured to manage the sending, through the transmission module 14, of the detected data and/or processed data.

The management unit 27 can be configured to become operational when the energy in the storage device 12 is sufficient. Alternatively, the management unit 27 can be powered by the buffer battery 24.

The transmission module 14 is configured to transmit information correlated to the at least one measured physical quantity. It can also be configured to transmit information correlated to the stored leakage energy. It can transmit information relating to the leakage current and/or other measured physical quantities, information on any events that have occurred, for example an absence of current due to a disconnection of the power supply of the line/plant or machine, the breakage of the insulator or suchlike.

By way of example, a minimum set of data transmitted by the apparatus 10 comprises the identifier of the insulating element 10, information on the leakage current (type of measurement, value, measurement uncertainty) and events that occurred. More complex messages can be sent with longer transmission periods, and also contain information such as the identifier and status of the apparatus 10, statistics on the data and events that occurred or suchlike. The complexity of the messages can be correlated to an estimate or statistic of the amplitude of the leakage current, in order to optimize the data sending intervals.

The transmission module 14 is a long-range transmission module, for example a LoRa module or suchlike. The transmission module is configured for transmission toward the Gateway 51.

The Gateway 51, with LoRa interface, receives the data from the apparatus 10 and sends them to a remote processing unit 52, which can also be provided with means for storing data in the cloud. The Gateway 51 can add a time reference to the data prior to sending.

In order to limit the energy consumption by the transmission module 14, it can be configured to allow communication at distances of a few kilometers, for example less than 2 km.

The transmission module 14 can be configured for transmission with intervals and communication profiles of the data sized according to the desired/possible energy consumption. In particular, the transmission module 14 can be configured by an operator in an initial stage of installation. Alternatively, it can be managed by the management unit 27 based on the availability of the leakage energy stored.

In addition to the transmission module 14, the management unit 27 can also manage, based on the availability of the leakage energy stored, the detection module 13, for example the sampling period of the detected signals or suchlike.

For example, the management unit 27 can cooperate with the detection module 13, the storage device 12 and the transmission module 14 to remotely transmit data to at least one processing unit 52 when a sufficient amount of energy is present in the storage device 12 to allow the transmission.

As a function of the time interval between one signal and the previous one, the processing unit 52 can estimate the amount of leakage current gradually collected.

For example, for leakage currents less than a few tens of microamperes, for example less than 30 µA, the sampling periods of the detections and transmissions of the data can be reduced.

The apparatus 10 comprises a local communication device 28, configured to allow interfacing with an operator for the configuration of the apparatus 10, for example for the first installation of the apparatus 10 or subsequent maintenance thereof.

The local communication device 28 can be configured to save/identify information relating to characteristics of the insulating element 100 or of the equipment 110 with which it is associated, for example the type of material, or predefined reference working parameters, to enable/configure the monitoring activities of the apparatus 10, for example the sampling period and/or the communication interval of the data to the Gateway 51 or suchlike.

The local communication device 28 can be a reading/writing device, for reading the information saved therein but also for modifying it.

The local communication device 28 can preferably be a short-range wireless transmitting device, but also a wired device, comprising for example a USB, Ethernet or similar port.

The short-range transmitting device can be chosen from an RFID device, an NFC device, an infrared device, or suchlike. Preferably, the local communication device 28 is an RFID device.

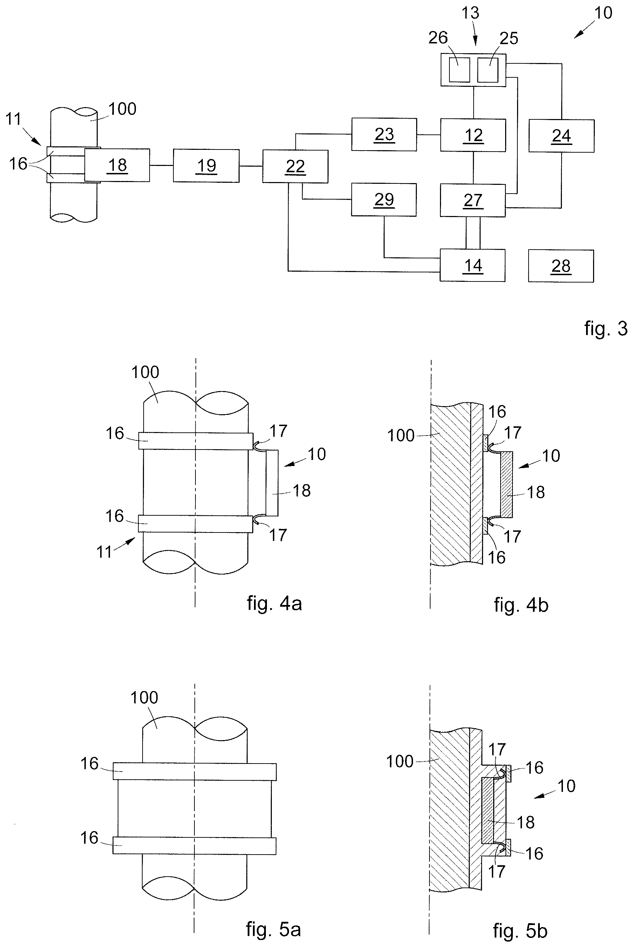

As shown in fig. 3, the detection module 13 can comprise a second leakage current measurement device 29. The measurement device 29 can be additional or alternative to the first measurement device 25.

The second measurement device 29 comprises a leakage current acquisition circuit and a data processing circuit for processing the leakage current measurement.

By way of example, the second measurement device 29 can supply data relating to an average current, understood as the average of the leakage current that has passed through the insulating element 100 during the sampling period, an instantaneous current, that is, the intensity of the leakage current at the time of sampling, or similar data.

Preferably, the second measurement device 29 supplies data relating to an instantaneous current.

The apparatus 10 also comprises a division device 22 (fig. 3) configured to send one part of the leakage current to the storage device 12 and another part of the leakage current to the second measurement device 29. Preferably, the division device 31 is a low-consumption device.

The division device 22 is chosen from a switch, a divider or suchlike, preferably it is a switch.

The division device 22 embodied as a switch allows the leakage current to be sent, in a first position, to the storage device 12 and, in a second position, to the second measurement device 29. The division of the energy associated with the leakage current between the storage device 12 and the second measurement device 29 therefore occurs over time. For example, in the event that the second measurement device 29 supplies data relating to an instantaneous current, the division device 22 sends the leakage current to the second measurement device 29 only in the sampling instant; advantageously, in this case the amount of stored leakage current is optimized.

The division device 22 embodied as a divider divides the leakage current into a first part, sent to the storage device 12, and into a second part, sent to the second measurement device 29.

In particular, the management unit 27 can be configured to control the division device 22 in order to manage the parts of the leakage current to be sent to the second measurement device 29 and to the storage device 12, respectively.

According to one embodiment and as shown in figs. 4a and 4b, the apparatus 10 can be attached externally to the insulating element 100, with the collection element 11, and in particular the strips 16, positioned in contact with the surface of the insulating element 100.

According to one variant and as shown in figs. 5a and 5b, the collection element 11, and in particular the strips 16, can be positioned on the surface of the insulating element 100, while the remaining parts of the apparatus 10 can be incorporated inside the insulating element 100, for example inside a layer of silicone, fiberglass or suchlike. Advantageously, it is thus possible to protect the apparatus 10 from the external environment, possibly it is possible to shield it in order to reduce electromagnetic interferences or it is possible to achieve similar advantages.

According to some embodiments, for example described with reference to fig. 1, the apparatus 10 comprises a support body 30 suitable to house inside it and/or support externally thereto the components of the apparatus 10.

According to some embodiments, in or on the support body there are housed or, respectively, connected at least the storage device 12, the detection module 13 and the at least one measurement device 25, 29 and the data transmission module 14, the management unit 27 and, if present, the possible local communication device 28 and/or the buffer battery 24.

According to some embodiments, the support body 30 can be divided into three parts 31, 32, 33, which are disposed one adjacent to the other to form a "C" and are connected in correspondence with respective lateral edges by means of flexible connection elements 34, so as to allow to spread apart the first and third part 31, 33 and facilitate the positioning of the apparatus 10 around an insulating element 100.

The present invention also concerns a monitoring platform 50 comprising at least one monitoring apparatus 10, a Gateway 51, at least one processing unit 52 configured to process and possibly save the received data and one or more local terminals 53.

According to some embodiments, the platform 50 comprises a plurality of groups/sub-groups G1, G2 of monitoring apparatuses 10, wherein at least the monitoring apparatuses 10 of one group G1, G2 are configured to communicate with each other or simultaneously transmit signals to at least one data processing and storage unit 52. In this case, the data processing and storage unit 52 can be configured to process the received signals and obtain additional information on the characteristics of one or more of the apparatuses 10 of one group G1, G2, or on the characteristics of the equipment 110 respectively associated with the group G1, G2. The operation of the apparatus 10 described heretofore, which corresponds to the method for monitoring an insulating element 100 according to the present invention, comprises the following steps:
- connecting an apparatus 10 to an insulating element 100 associated with, or located in proximity to, equipment 110 configured to operate with high electric voltages and/or currents;
- collecting the surface leakage current of the insulating element 100 by means of conductive grip elements 17 placed in contact with it;
- sending the energy associated with the leakage current to the storage device 12;
- powering the detection module 13 by means of the storage device 12 and detecting the leakage current on the basis of the stored energy;
- transmitting at least information relating to a physical quantity correlated to the leakage current measured by the detection module 13 by means of the remote transmission module 14.

The method comprises carrying out a measurement of the leakage current.

The aforementioned measurement of the leakage current can be carried out indirectly and/or directly.

The method comprises indirectly carrying out the measurement of the leakage current, detecting data correlated to it.

For example, a correlated datum may be the speed of variation of the charge level of a component of the storage device 12 in which all or part of the leakage current is sent, for example a capacitor.

As another example, a correlated datum may be the charging time of a component of the storage device 12.

The data can only be sent when the leakage energy stored in the storage device 12 is sufficient to send the data.

The amount of data to be sent can be chosen based on the voltage present, during use, on the line 102/plant/machine.

By way of example, for a 200 kV line 102, the sending time may be shorter than ten minutes, for example 6 or 7 minutes; for an 88 kV line 102, the sending time may be even longer than 45 minutes.

The method comprises carrying out the measurement of the leakage current directly, by means of a second current measurement device 29; the leakage current is, in this case, divided into two parts, one sent to the storage device 12 and the other to the second measurement device 29.

The method provides that the apparatus 10 can be associated with or located in proximity to equipment 110, such as for example on a line 102/plant/machine, either powered or non-powered, for example at the time of installation or maintenance.

In the case of powered equipment 110, the energy for the operation of the apparatus 10 is the stored leakage energy.

In the case of non-powered equipment 110, the energy for the operation of the apparatus 10 is the energy of the buffer battery 24.

The method comprises positioning, separated from each other, two conductive strips 16 of the collection element 11 in contact with the insulating element 100.

According to some embodiments, the strips 16 can also be positioned on the insulating element 100 at the time of production of the latter, and subsequently the apparatus 10 can be connected to them.

According to some embodiments, the method then comprises positioning the conductive grip elements 17, each connected to one end of the coupling element 18 of the apparatus 10, in contact with the strips 16, so as to create a low impedance path for the leakage current.

According to some embodiments, in the event that the grip elements 17 also have the function of mechanical support, if for example they are made of flexible material, the positioning of the latter allows to simultaneously obtain a mechanical coupling between the apparatus 10 and the insulating element 100.

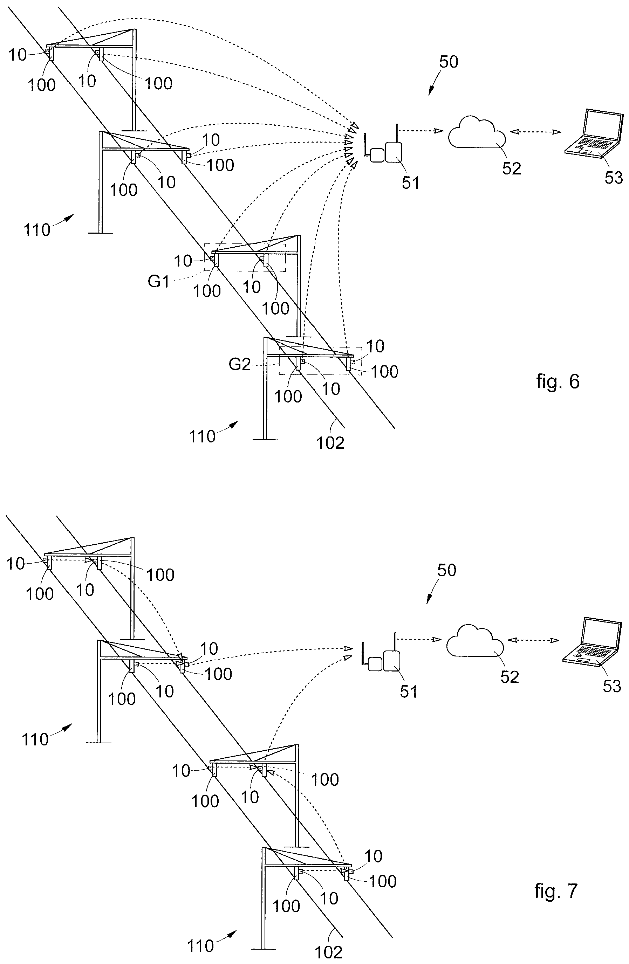

The method can provide (figs. 6 and 7) to use a plurality of apparatuses 10, for example for monitoring multiple points/elements of equipment 110 such as a line 102/plant/machine.

In this case, the method can provide (fig. 6) that each apparatus 10 communicates autonomously with the Gateway 51. Alternatively, the method can provide that all (fig. 7) or each apparatus 10 of a sub-group of apparatuses 10 communicate with the next apparatus 10, and that only the last apparatus 10, or the last apparatus 10 of the sub-group, communicates with the Gateway 51.

The method can provide to use the plurality of apparatuses 10 as above to carry out redundant measurements in order to detect the non-ideality of the surface of the insulating element 100.

By way of example, the method can provide to send the data on different paths in order to detect if a possible malfunction/failure in communication is due to one or more of the communication modules 14, to the Gateway 51 or to any obstacles present on the segments between one or more communication modules 14 and the Gateway 51.

In particular, a Received Signal Strength Indication (RSSI) measurement may be used.

The RSSI measurement is influenced both by the characteristics of the receiving system, in the present example the Gateway 51, and also by the characteristics of the transmitting system, in the present example the transmission module 14, as well as by the communication channel, that is, the environment between the Gateway 51 and the transmission module 14. For example, a "low" RSSI could be caused by:
- a malfunctioning antenna, or one covered by material that prevents the correct adaptation of the receiving system and/or the transmitting system;
- situations of interfered communication channel, for example an obstacle to the view between the antennas;
- combinations of the above.

The method therefore provides to use redundant RSSI measurements (a single value, and therefore a single path of the signal sent, is not sufficient) to discriminate between transmission errors/malfunctions caused by one or more pairs of transmitting system-receiving system, or the set transmitter-receiving channel and a non-ideality of the surface of the insulating element 100, caused as previously said by a possible layer of material, such as dirt, ice, salt or water, deposited on the surface of the insulating element 100 and therefore on an antenna of the transmission module 14.

For example, the RSSI of a communication can be used as a model of proportionality to the impedance adaptations of the antennas of the transmitting system i and of the receiving system j, having a relationship of the type: $RSSIij = C Ki Kj$ where:
RSSIij: RSSI of the signal transmitted by i and received by j;
C: proportionality constant;
Ki: adaptive impedance of the antenna of the system i;
Kj: adaptive impedance of the antenna of the system j;

In systems in which the signal of a transmitting system can be received by several receiving systems, an appropriate mathematical treatment allows to solve Ki and therefore identify the state of the surface of the individual insulating elements 100.

As another example, the following model can also be used: $RSSIij = C Ki Hij Kj$ where:
RSSIij: RSSI of the signal transmitted by i and received by j;
C: proportionality constant;
Ki: adaptive impedance of the antenna of the system i;
Kj: adaptive impedance of the antenna of the system j;
Hij: impedance of the communication channel between systems i and j.

In particular, if the insulating elements 100 are insulators located on a same pylon, a similar modelling can be solved by using the pylon impedances T as parameters Hij, for example as a function of the parameters Hij, such as a summation (Σ Hij) or product (Π Hij) of Hij, or suchlike.

In the example case of 4 communication modules 14, named A, B, C, D, the data can be sent, on a first path, from A to B and then to C, and on a second path, from A to D and then to C. The data received by the Gateway 51 can then be processed to identify the possible non-ideality of the surface of the insulating element 100 or a different malfunction/failure on the individual paths.

It is clear that modifications and/or additions of parts and/or steps may be made to the apparatus 10, to the platform 50 and to the method as described heretofore, without departing from the field and scope of the present invention, as defined by the claims.

It is also clear that, although the present invention has been described with reference to some specific examples, a person of skill in the art will be able to achieve other equivalent forms of apparatus, monitoring platform and corresponding operating method, having the characteristics as set forth in the claims and hence all coming within the field of protection defined thereby.

In the following claims, the sole purpose of the references in brackets is to facilitate their reading and they must not be considered as restrictive factors with regard to the field of protection defined by the claims.

## Claims

1. Monitoring apparatus (10) for an insulating element (100), comprising a surface leakage current collection element (11) provided with two conductive grip elements (17) configured to be connected, during use, to an insulating element (100), a device (12) for storing the energy associated with said leakage current, a detection module (13) configured to detect said leakage current and a remote transmission module (14) configured to be powered by said storage device (12) and to transmit at least the information relating to a physical quantity correlated to said leakage current measured by said detection module (13),
**characterized in that**
the detection module (13) is configured to detect said leakage current on the basis of said stored energy.

2. Apparatus (10) as in claim 1, **characterized in that** said detection module (13) comprises at least one measurement device (25) configured to cooperate with said storage device (12) for the indirect measurement of said leakage current based on the speed of variation of said leakage energy stored in said storage device (12) and/or based on the charging time of said storage device (12).

3. Apparatus (10) as in claim 1 or 2, **characterized in that** said detection module (13) comprises a first (25) and a second device (29) for measuring the leakage current and a division device (22), chosen from a switch or a divider, configured to send a part of said leakage current to said storage device (12) and another part to said second measurement device (29).

4. Apparatus (10) as in any claim from 1 to 3, **characterized in that** said detection module (13) comprises at least one device (26) for detecting the mechanical stress on the structure of said insulating element (100) and/or of equipment (110) with which said insulating element (100) is associated **and in that** said at least one detection device (26) is a strain gauge or an ultrasonic sensor.

5. Apparatus (10) as in any claim from 1 to 4, **characterized in that** said collection element (11) comprises two conductive strips (16), configured to be placed in contact with the surface of said insulating element (100), distanced from each other, and said grip elements (17) are configured to be placed in contact with said strips (16) and each connected to one end of a coupling element (18) of said apparatus (10), said coupling element (18) comprising a low impedance path for the leakage current.

6. Apparatus (10) as in any claim from 1 to 5, **characterized in that** it comprises at least one buffer battery (24) for powering the apparatus (10) when said stored leakage energy is not sufficient.

7. Monitoring platform (50) for an insulating element (100) comprising a monitoring apparatus (10) as in any claim from 1 to 6, a Gateway (51), one or more data processing and storage units (52) and one or more local terminals (53).

8. Platform (50) as in claim 7, **characterized in that** it comprises at least one group (G1, G2) of monitoring apparatuses (10) connected to insulating elements (100) associated with, or located in correspondence with, a same equipment (110), wherein the apparatuses of said group (G1, G2) are configured to communicate with each other or simultaneously transmit signals to at least one data processing and storage unit (52), which is configured to process and cross said received signals and obtain additional information on the characteristics of one of the apparatuses (10) of said group (G1, G2) or on the characteristics of said equipment (110) associated with said group (G1, G2).

9. Method for monitoring an insulating element (100), comprising:
- connecting a monitoring apparatus (10) to an insulating element (100) associated with, or located in proximity to, equipment (110) configured to operate with high electric voltages and/or currents;
- collecting a surface leakage current of said insulating element (100) by means of conductive grip elements (17) of said apparatus (10) placed in contact with it;
- sending the energy associated with said leakage current to a storage device (12);
- powering a detection module (13) by means of said storage device (12);
**characterized in**
detecting a leakage current on the basis of said stored energy;
- transmitting, by means of a remote transmission module (14), at least information relating to a physical quantity correlated to said leakage current measured.

10. Method as in claim 9, **characterized in that** it comprises carrying out a measurement of the leakage current indirectly, by detecting the speed of variation of the charge level and/or the charging time of said storage device (12).

11. Method as in claim 9 or 10, **characterized in that** it comprises carrying out a direct measurement of said leakage current by dividing said leakage current into two parts, and sending one part to said storage device (12) and another part to a dedicated measurement device (29).

12. Method as in any claim from 9 to 11, **characterized in that** it comprises detecting the non-ideality of the surface of said insulating element (100) by means of redundant measurements of the received signal strength (RSSI - Received Signal Strength Indication) on different communication paths between a multiplicity of said apparatuses (10).

## Patentansprüche

1. Überwachungsvorrichtung (10) für ein Isolierelement (100), umfassend ein Oberflächenleckstrom-Sammelelement (11), das mit zwei leitfähigen Greifelementen (17) versehen ist, die so konfiguriert sind, dass sie im Betrieb mit einem Isolierelement (100) verbunden werden können, eine Vorrichtung (12) zum Speichern der mit dem Leckstrom verbundenen Energie, ein Erfassungsmodul (13), das so konfiguriert ist, dass es den Leckstrom erfasst, und ein Fernübertragungsmodul (14), das so konfiguriert ist, dass es von der Speichervorrichtung (12) mit Energie versorgt wird und zumindest die Informationen überträgt, die sich auf eine physikalische Größe beziehen, die mit dem vom Erfassungsmodul (13) gemessenen Leckstrom korreliert, **dadurch gekennzeichnet, dass** das Erfassungsmodul (13) so konfiguriert ist, dass es den Leckstrom auf der Grundlage der gespeicherten Energie erfasst.

2. Vorrichtung (10) nach Anspruch 1, **dadurch gekennzeichnet, dass** das Erfassungsmodul (13) mindestens eine Messvorrichtung (25) umfasst, die so konfiguriert ist, dass sie mit der Speichervorrichtung (12) zusammenwirkt, um den Leckstrom indirekt auf der Grundlage der Geschwindigkeit der Änderung der in der Speichervorrichtung (12) gespeicherten Leckstromenergie und/oder auf der Grundlage der Ladezeit der Speichervorrichtung (12) zu messen.

3. Vorrichtung (10) nach Anspruch 1 oder 2, **dadurch gekennzeichnet, dass** das Erfassungsmodul (13) eine erste (25) und eine zweite Messvorrichtung (29) zur Messung des Leckstroms sowie eine Aufteilvorrichtung (22) - ausgewählt aus einem Schalter oder einem Teiler - umfasst, die so konfiguriert ist, dass sie einen Teil des Leckstroms an die Speichervorrichtung (12) und einen anderen Teil an die zweite Messvorrichtung (29) leitet.

4. Vorrichtung (10) nach einem der Ansprüche 1 bis 3, **dadurch gekennzeichnet, dass** das Erfassungsmodul (13) mindestens eine Vorrichtung (26) zum Erfassen der mechanischen Belastung an der Struktur des Isolierelements (100) und/oder einer Einrichtung (110), mit der das Isolierelement (100) verbunden ist, umfasst, **und dass** die mindestens eine Erfassungsvorrichtung (26) ein Dehnungsmessstreifen oder ein Ultraschallsensor ist.

5. Vorrichtung (10) nach einem der Ansprüche 1 bis 4, **dadurch gekennzeichnet, dass** das Sammelelement (11) zwei leitfähige Streifen (16) umfasst, die so konfiguriert sind, dass sie mit der Oberfläche des Isolierelements (100) in Kontakt gebracht werden und voneinander beabstandet sind, und die Greifelemente (17) so konfiguriert sind, dass sie mit den Streifen (16) in Kontakt gebracht werden und jeweils mit einem Ende eines Kopplungselements (18) der Vorrichtung (10) verbunden sind, wobei das Kopplungselement (18) einen niederohmigen Pfad für den Leckstrom umfasst.

6. Vorrichtung (10) nach einem der Ansprüche 1 bis 5, **dadurch gekennzeichnet, dass** sie mindestens eine Pufferbatterie (24) zur Stromversorgung der Vorrichtung (10) umfasst, wenn die gespeicherte Leckstromenergie nicht ausreicht.

7. Überwachungsplattform (50) für ein Isolierelement (100), umfassend eine Überwachungsvorrichtung (10) gemäß einem der Ansprüche 1 bis 6, ein Gateway (51), eine oder mehrere Datenverarbeitungs- und Speichereinheiten (52) sowie ein oder mehrere lokale Endgeräte (53).

8. Plattform (50) nach Anspruch 7, **dadurch gekennzeichnet, dass** sie mindestens eine Gruppe (G1, G2) von Überwachungsvorrichtungen (10) umfasst, die mit Isolierelementen (100) verbunden sind, die einer gleichen Einrichtung (110) zugeordnet oder in Übereinstimmung mit dieser angeordnet sind, wobei die Vorrichtungen dieser Gruppe (G1, G2) so konfiguriert sind, dass sie miteinander kommunizieren oder gleichzeitig Signale an mindestens eine Datenverarbeitungs- und Speichereinheit (52) senden, die so konfiguriert ist, dass sie die empfangenen Signale verarbeitet und kreuzt und zusätzliche Informationen über die Eigenschaften einer der Vorrichtungen (10) der Gruppe (G1, G2) oder über die Eigenschaften der mit der Gruppe (G1, G2) verbundenen Einrichtung (110) gewinnt.

9. Verfahren zur Überwachung eines Isolierelements (100), umfassend:
- das Anschließen einer Überwachungsvorrichtung (10) an ein Isolierelement (100), das mit einer Einrichtung (110) verbunden ist oder sich in deren Nähe befindet, die für den Betrieb mit hohen elektrischen Spannungen und/oder Strömen konfiguriert ist;
- das Erfassen eines Oberflächenleckstroms des Isolierelements (100) mittels leitfähiger Greifelemente (17) der Vorrichtung (10), die mit diesem in Kontakt stehen;
- das Leiten der mit dem Leckstrom verbundenen Energie an eine Speichervorrichtung (12);
- das Versorgen eines Erfassungsmoduls (13) mittels der Speichervorrichtung (12),
**gekennzeichnet durch**
- das Erfassen eines Leckstroms auf der Grundlage der gespeicherten Energie;
- das Übertragen, mittels eines Fernübertragungsmoduls (14), zumindest von Informationen bezüglich einer physikalischen Größe, die mit dem gemessenen Leckstrom korreliert.

10. Verfahren nach Anspruch 9, **dadurch gekennzeichnet, dass** es das Durchführen einer indirekten Messung des Leckstroms durch Erfassen der Geschwindigkeit der Änderung des Ladezustands und/oder der Ladezeit der Speichervorrichtung (12) umfasst.

11. Verfahren nach Anspruch 9 oder 10, **dadurch gekennzeichnet, dass** es das Durchführen einer direkten Messung des Leckstroms umfasst, indem der Leckstrom in zwei Teile aufgeteilt wird und ein Teil an die Speichervorrichtung (12) und ein anderer Teil an eine dedizierte Messvorrichtung (29) geleitet wird.

12. Verfahren nach einem der Ansprüche 9 bis 11, **dadurch gekennzeichnet, dass** es das Erfassen der Nichtidealität der Oberfläche des Isolierelements (100) mittels redundanter Messungen der empfangenen Signalstärke (RSSI - Received Signal Strength Indication) auf verschiedenen Kommunikationswegen zwischen einer Vielzahl der Vorrichtungen (10) umfasst.

## Revendications

1. Appareil de surveillance (10) pour un élément isolant (100), comprenant un élément de collecte de courant de fuite de surface (11) pourvu de deux éléments de préhension conducteurs (17) configurés pour être connectés, lors de l'utilisation, à un élément isolant (100), un dispositif (12) de stockage de l'énergie associée audit courant de fuite, un module de détection (13) configuré pour détecter ledit courant de fuite et un module de transmission à distance (14) configuré pour être alimenté par ledit dispositif de stockage (12) et pour transmettre au moins l'information relative à une grandeur physique corrélée audit courant de fuite mesuré par ledit module de détection (13), **caractérisé en ce que** le module de détection (13) est configuré pour détecter ledit courant de fuite sur la base de ladite énergie stockée.

2. Appareil (10) selon la revendication 1, **caractérisé en ce que** ledit module de détection (13) comprend au moins un dispositif de mesure (25) configuré pour coopérer avec ledit dispositif de stockage (12) pour la mesure indirecte dudit courant de fuite sur la base de la vitesse de variation de ladite énergie de fuite stockée dans ledit dispositif de stockage (12) et/ou sur la base du temps de charge dudit dispositif de stockage (12).

3. Appareil (10) selon la revendication 1 ou 2, **caractérisé en ce que** ledit module de détection (13) comprend un premier (25) et un second dispositif (29) de mesure du courant de fuite et un dispositif de division (22), choisi parmi un commutateur ou un diviseur, configuré pour envoyer une partie dudit courant de fuite audit dispositif de stockage (12) et une autre partie audit second dispositif de mesure (29).

4. Appareil (10) selon l'une quelconque des revendications 1 à 3, **caractérisé en ce que** ledit module de détection (13) comprend au moins un dispositif (26) de détection de la contrainte mécanique sur la structure dudit élément isolant (100) et/ou de l'équipement (110) auquel ledit élément isolant (100) est associé et **en ce que** ledit au moins un dispositif de détection (26) est une jauge de contrainte ou un capteur ultrasonique.

5. Appareil (10) selon l'une quelconque des revendications 1 à 4, **caractérisé en ce que** ledit élément de collecte (11) comprend deux bandes conductrices (16), configurées pour être mises en contact avec la surface dudit élément isolant (100), espacées l'une de l'autre, et lesdits éléments de préhension (17) sont configurés pour être mis en contact avec lesdites bandes (16) et chacun connecté à une extrémité d'un élément de couplage (18) dudit appareil (10), ledit élément de couplage (18) comprenant un chemin à faible impédance pour le courant de fuite.

6. Appareil (10) selon l'une quelconque des revendications 1 à 5, **caractérisé en ce qu'**il comprend
au moins une batterie tampon (24) pour alimenter l'appareil (10) lorsque ladite énergie de fuite stockée n'est pas suffisante.

7. Plateforme de surveillance (50) pour un élément isolant (100) comprenant un appareil de surveillance (10) selon l'une quelconque des revendications 1 à 6, une passerelle (51), une ou plusieurs unités de traitement et de stockage de données (52) et un ou plusieurs terminaux locaux (53).

8. Plateforme (50) selon la revendication 7, **caractérisée en ce qu'**elle comprend au moins un groupe (G1, G2) d'appareils de surveillance (10) connectés à des éléments isolants (100) associés à, ou situés en correspondance avec, un même équipement (110), lequel groupe d'appareils (G1, G2) est configuré pour communiquer entre eux ou transmettre simultanément des signaux à au moins une unité de traitement et de stockage de données (52), laquelle est configurée pour traiter et croiser lesdits signaux reçus et obtenir des informations supplémentaires sur les caractéristiques de l'un des appareils (10) dudit groupe (G1, G2) ou sur les caractéristiques dudit équipement (110) associé audit groupe (G1, G2).

9. Procédé de surveillance d'un élément isolant (100), comprenant :
- connecter un appareil de surveillance (10) à un élément isolant (100) associé à, ou situé à proximité de, un équipement (110) configuré pour fonctionner avec des tensions et/ou des courants électriques élevés;
- collecter un courant de fuite de surface dudit élément isolant (100) au moyen d'éléments de préhension conducteurs (17) dudit appareil (10) mis en contact avec celui-ci;
- envoyer l'énergie associée audit courant de fuite à un dispositif de stockage (12);
- alimenter un module de détection (13) au moyen dudit dispositif de stockage (12); **caractérisé par**
détecter un courant de fuite sur la base de ladite énergie stockée;
- transmettre, au moyen d'un module de transmission à distance (14), au moins une information relative à une grandeur physique corrélée audit courant de fuite mesuré.

10. Procédé selon la revendication 9, **caractérisé en ce qu'**il comprend d'effectuer une mesure du courant de fuite de manière indirecte, en détectant la vitesse de variation du niveau de charge et/ou le temps de charge dudit dispositif de stockage (12).

11. Procédé selon la revendication 9 ou 10, **caractérisé en ce qu'**il comprend d'effectuer une mesure directe dudit courant de fuite en divisant ledit courant de fuite en deux parties, et en envoyant une partie audit dispositif de stockage (12) et une autre partie à un dispositif de mesure dédié (29).

12. Procédé selon l'une quelconque des revendications 9 à 11, **caractérisé en ce qu'**il comprend de détecter la non-idéalité de la surface dudit élément isolant (100) au moyen de mesures redondantes de la puissance du signal reçu (RSSI - Received Signal Strength Indication) sur différents chemins de communication entre une multiplicité desdits appareils (10).
